# EUROPEAN PATENT APPLICATION

(11) **EP 0 948 050 A1**
(43) Date of publication of application: **06.10.1999**
(21) Application number: 98830172.7
(22) Date of filing: 24.03.1998
(51) Int. Cl.: H01L 27/02, H01L 23/485

(54) **Electronic semiconductor power device with polycrystalline silicon components**

(71) Applicant: STMicroelectronics S.r.l., 20041 Agrate Brianza (Milano) (IT)
(72) Inventor: Frisina, Feruccio, 95030 Sant'Agata Li Battiati, Catania (IT); Percolla, Giuseppe, 95040 Motta Sant'Anastasia, Catania (IT); Fragapane, Leonardo, 95121 Catania (IT)
(74) Representative: Maggioni, Claudio

(57) **Abstract**

The device comprises a chip of semiconductor material (10), a plate (14) of insulating material on the chip, a conducting strip of doped semiconductor material which has a portion (15) which extends over the plate (14), a portion (16) of a layer of semiconductor material which extends over the plate (14) and contains active regions and a metallic element (17) which is in contact with the portion (15) of conducting strip which extends over the plate (14) and has an area (20) designed to be used for electrical connection to a terminal, outside the chip, of the electronic device. To increase the useful area of the chip, the metallic element (17) extends in large part over the portion (16) of the layer of semiconductor material containing active regions, and is separated from this portion (16) by a layer of insulating material.

## Description

The present invention relates to electronic semiconductor devices and, more particularly, to an electronic power device as defined in the precharacterizing clause of the first claim.

There are known semiconductor power devices which comprise, in addition to the usual active regions formed in a chip of semiconductor material, for example monocrystalline silicon, active regions formed in a layer of semiconductor material, for example polycrystalline silicon, insulated from the chip.

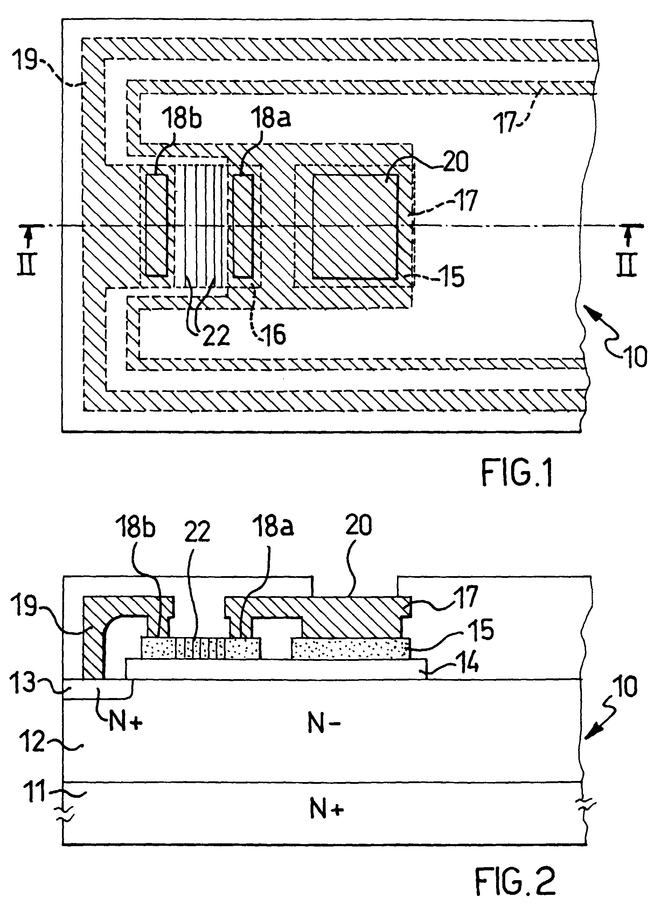

A device of this kind comprises a voltage-controlled power component such as a MOS transistor, an IGBT (insulated gate bipolar transistor), an MCT (MOS controlled thyristor), etc., in which a layer of polycrystalline silicon is used both to form the gate electrode of the power component and to form an integrated protective structure; alternatively it may comprise a bipolar power transistor with a separate protective structure formed in polycrystalline silicon. Figures 1 and 2 show in schematic and partial form, in plan and in section respectively, a known device made in P-MOS technology, limited to some of its significant parts, to illustrate the problem which gave rise to the present invention.

A monocrystalline silicon chip, indicated as a whole by the number 10, consists of an n-type substrate 11 which has high conductivity and is therefore indicated by N+, and an epitaxial layer 12 which has low conductivity and is therefore indicated by N-. In the epitaxial layer 12 there are formed various active regions of the device, of which only one highly doped perimetric n-type region 13 is shown; this has the function of providing ohmic contact between the chip 10 and a metallic strip 19 which extends around the whole edge of the chip and acts as an equipotential ring.

A plate 14 of insulating material, for example silicon dioxide, made by the known method of selective high-temperature oxidation of silicon, is formed on the epitaxial layer 12. A conducting strip of doped polycrystalline silicon forms the gate electrode of a MOS power transistor. Figure 2 shows in section only the portion, indicated by 15, of this strip which extends over the plate 14. The gate electrode itself, which is not shown, extends, as is known, over the channel region of the transistor, being insulated from the surface of the epitaxial layer 12 by a thin layer of dielectric. On the plate 14 there is also formed a portion 16 of polycrystalline silicon, which is produced preferably from the same layer of polycrystalline silicon from which the gate electrode is produced, but is treated differently. In particular, the polycrystalline silicon of the gate electrode is doped heavily, so that it becomes a good conductor, and the polycrystalline silicon of the portion 16 is subjected to selective doping and interconnection operations in such a way as to produce active regions connected together in a predetermined way to form an electronic circuit.

The electronic circuit may be, for example, a voltage limiting device connected between the gate electrode 15 and the epitaxial layer 12 to prevent the overvoltage effect due to anomalous situations during the operation of the device. Such a circuit may be formed essentially from a certain number of diodes, formed by parallel strips 22 doped n and p alternately, connected in series to each other with alternating orientation, according to a known method which makes it possible to obtain a precise trigger voltage having a low sensitivity to temperature variations. It is possible to produce diodes each of which has a reverse conducting voltage of approximately 10 V, so that in order to obtain a protection voltage of 400 V it will be necessary to have 40 diodes connected in the reverse conducting direction. Other diodes, preferably another 40, have to be added to these and connected for forward conduction to compensate for the variation of the reverse breakdown voltage of the diodes with the variation of opposite sign of the voltage drop across the forward conducting diodes when the temperature varies.

This diode structure, in order to carry out its protective function, must be capable of conducting large currents and must therefore have a relatively large surface area.

A metallic element 17 extends over the gate electrode strip to establish an electrical contact with it. In particular, it covers a considerable part of the portion 15 and is also in contact with the portion 16 of polycrystalline silicon, or more precisely with an area 18a which forms a terminal electrode of the protective diode structure. Another metallic element 19 establishes an electrical connection between the other terminal electrode of the protective structure, indicated by an area 18b, and an area of the perimetric region 13.

A layer of insulating material, for example silicon dioxide, covers the whole structure with the exception of the areas of the metallic elements designed to be used for connection to the terminals of the device outside the silicon chip 10 by means of wires soldered on them. The drawing shows only the area, or pad, 20 for the contact between the gate electrode and the corresponding terminal. This area, in order to permit soldering, must be relatively large and therefore occupies, together with the underlying supporting structure, a not inconsiderable part of the silicon chip which cannot be used for the active regions of the device.

The principal object of the present invention is to increase the area of the chip which can be used for the active regions of the electronic power device.

This object is achieved by making the device defined and characterized in the first claim.

The invention will be better understood from the following detailed description of one embodiment of it provided by way of example, and therefore in no limiting sense, with reference to the attached drawings, in which:
- Figures 1 and 2 show, in plan and in section respectively, and in a schematic and partial way, a known device; and
- Figures 3 and 4 show, in plan and in section respectively, and again in a schematic and partial way, a device according to the invention.

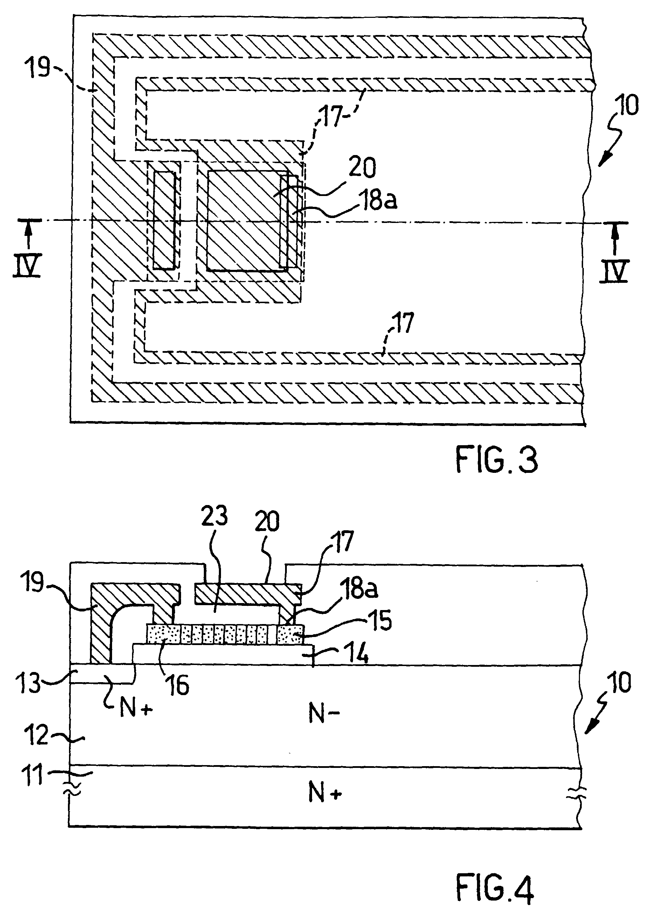

The device shown in Figures 3 and 4 is in many ways identical to the known device shown in Figures 1 and 2. Consequently, identical or corresponding parts are indicated by the same reference number or symbol and are not described again.

According to the invention, the portion 15 of the gate electrode which extends over the plate 14 is much narrower than that used in the prior art, and the metallic element 17 which forms the gate pad 20 for the soldering of a wire extends in large part over the portion 16 of polycrystalline silicon which contains a diode protection circuit such as that described in relation to the known device or a circuit having a different function. It is to be understood that the metallic element 17, with the exception of the connection 18a, is insulated from the portion 16 of polycrystalline silicon by an intermediate layer of insulating material, for example silicon dioxide.

In the example shown, the portion 15 of the gate electrode and the portion 16 of polycrystalline silicon are made in a single piece. If necessary, however, they may be made in the form of two separate elements.

It is evident that, according to the invention, the area of the chip 10 which can be used for the active regions is greater than that of a device according to the prior art formed on a chip having the same dimensions, since the part of the metallic element 17 having the pad 20 for contact with the external gate terminal extends entirely over the portion 16 of polycrystalline silicon containing the protective diodes. The increase in useful area is practically equal to the reduction of the extension of the silicon dioxide plate 14. In a practical case, the gain in area was approximately 5%.

It should be noted that the production of the device according to the invention requires no operations additional to those normally carried out; in fact, a change in the layout of some of the masks is sufficient.

## Claims

1. Electronic power device comprising
- a chip of semiconductor material (10),
- a plate (14) of insulating material on the chip (10),
- a conducting strip of doped semiconductor material which has a portion (15) which extends over the plate (14),
- a portion (16) of a layer of semiconductor material which extends over the plate (14) and contains active regions; and
- a metallic element (17) which is in contact with the portion (15) of conducting strip which extends over the plate (14) and has an area (20) designed to be used for electrical connection to a terminal of the electronic device outside the chip,
characterized in that the metallic element (17) extends in large part over the portion (16) of the layer of semiconductor material containing active regions, and is separated from this portion (16) by a layer of insulating material.

2. Device according to Claim 1, in which the conducting strip and the portion (16) of the layer which extends over the plate (14) are both formed from the same layer of semiconductor material.

3. Device according to Claim 2, in which the portion (15) of conducting strip and the portion (16) of the layer which extends over the plate (14) are made in a single piece.

4. Device according to Claim 1, 2 or 3, in which the semiconductor material of the conducting strip and of the portion (16) of the layer is polycrystalline silicon.

5. Device according to any one of the preceding claims, in which the conducting strip is the gate electrode of a power transistor and the terminal of the electronic device to which the aforesaid area of the metallic element is designed to be connected is the gate terminal.

6. Device according to Claim 5, in which the active regions contained in the portion (16) of the layer form part of an overvoltage protection device between the gate electrode and the chip of semiconductor material (10) and in which electrical connections (18, 19) are provided between a first terminal electrode of the protective device and the metallic element (17) and between a second terminal electrode of the protective device and an area (13) of the chip.
